# EUROPÄISCHE PATENTSCHRIFT

(11) **EP 2 420 587 B1**
(45) Veröffentlichungstag und Bekanntmachung des Hinweises auf die Patenterteilung: **31.10.2012**
(21) Anmeldenummer: 10173100.8
(22) Anmeldetag: 17.08.2010
(51) Int. Cl.: C23C 14/00, C23C 14/06

(54) **Verfahren zur Erzeugung einer farbigen Überzugsschicht mittels Kathodenstrahlzerstäuben**
Method for producing a coloured coating using cathodic sputtering
Procédé de production d'une couche de revêtement colorée à l'aide de pulvérisateurs de faisceau cathodique

(43) Veröffentlichungstag der Anmeldung: 22.02.2012
(73) Patentinhaber: Helmholtz-Zentrum Geesthacht Zentrum für Material- und Küstenforschung GmbH, 21502 Geesthacht (DE)
(72) Erfinder: Störmer, Michael, 21031, Hamburg (DE); Hort, Norbert, 21339, Lüneburg (DE); Kainer, Karl-Ulrich, 21522, Hohnstorf (DE)
(74) Vertreter: UEXKÜLL & STOLBERG

(56) Entgegenhaltungen:
- US-A1- 2005 026 000
- BANAKH O ET AL: "Spectroellipsometric evaluation of colour and oxidation resistance of TiMgN coatings", THIN SOLID FILMS, ELSEVIER-SEQUOIA S.A. LAUSANNE, CH, Bd. 455-456, 1. Mai 2004 (2004-05-01), Seiten 650-655, XP004504865, ISSN: 0040-6090, DOI: DOI:10.1016/J.TSF.2003.11.218
- CHOI W S ET AL: "Microstructure and chemical state of Ti1-xYxN film deposited by reactive magnetron sputtering", JOURNAL OF VACUUM SCIENCE AND TECHNOLOGY: PART A, AVS /AIP, MELVILLE, NY., US, Bd. 18, Nr. 6, 1. November 2000 (2000-11-01), Seiten 2914-2921, XP012005397, ISSN: 0734-2101, DOI: DOI:10.1116/1.1319680

## Beschreibung

Die vorliegende Erfindung betrifft ein Verfahren zur Herstellung farbiger Überzugsschichten auf einem Substrat, das vorzugsweise metallisches Substrat ist.

### Beschreibung des Standes der Technik

Gewöhnlich werden farbige Überzugsschichten auf metallischen Substraten wie Telefon-, Rechner- und Uhrengehäusen durch das Aufbringen einer Lackierung hergestellt. Dabei ist es notwendig die Oberflächen der metallischen Substrate vorzubehandeln. Gegebenenfalls müssen Vermittlerschichten aufgebracht werden, damit die Lackierung an den Substratoberflächen haften kann. Sowohl bei der Vorbehandlung der Substratoberflächen, als auch bei der Austrocknung der Lacke nach erfolgter Beschichtung werden gewöhnlich Lösungsmittel freigesetzt. Dies ist unerwünscht.

Ferner können Lackschichten durch vergleichsweise geringe mechanische Einwirkung beschädigt oder zerstört werden. Auch sind sie in vielen Fällen nicht gegenüber Chemikalien wie Säuren oder organischen Lösungsmitteln resistent. Schließlich schützen konventionelle Lackierungen die Metalloberfläche nur unzureichend vor Korrosion.

Kathodenstrahlzerstäuben unter Einsatz eines Edelgas und Stickstoff enthaltenden Gasgemisches und unter Verwendung einer Kombination von zwei Beschichtungsstoffen (Targets) aus Scandium bzw. Zirkon zur Erzeugung kupferfarbener bis bronzefarbener Überzugsschichten ist aus US2005/0026000 bekannt.

Aufgabe der vorliegenden Erfindung ist es daher ein Verfahren zur Herstellung farbiger Überzugsschichten auf einem Substrat wie einem Metallsubstrat bereitzustellen, das all diese Nachteile nicht aufweist.

### Zusammenfassung der Erfindung

Die Aufgabe wird durch ein Verfahren nach Anspruch 1 gelöst. Bevorzugte Ausführungsarten sind in den Unteransprüchen 2-11 angegeben.

### Detaillierte Beschreibung der Erfindung

Kathodenstrahlzerstäubungsverfahren (Sputterverfahren) zum Beschichten von Substraten, bei welchen in einer Vakuumkammer durch ein Plasma Ionen erzeugt werden, die in Richtung einer Kathode beschleunigt werden und dort auf ein zu zerstäubendes Material, nämlich den Beschichtungswerkstoff (Target) auftreffen, sind allgemein bekannt. Ein derartiges Verfahren wird beispielsweise in der EP 1 826 811 A1 beschrieben, auf die hier Bezug genommen wird. Im vorliegenden Fall wird Magnesium und ein Seltenerdelement, ausgewählt aus der Gruppe bestehend aus La, Y, Ce, Pr, Nd, Pm, Sm, Eu, Gd, Tb, Dy, Ho, Er, Tm, Yb, Lu als Beschichtungsstoff verwendet. Es werden Kombinationen zweier Beschichtungswerkstoffe verwendet. Der Begriff "Kombination" bedeutet im vorliegenden Zusammenhang eine Kombination von mindestens zwei getrennten Beschichtungsstoffen (Targets), die durch unterschiedliche Kathodenstrahlen zerstäubt werden. So wird eine Kombination von Magnesium als ein erster Beschichtungsstoff und mindestens eines Seltenerdelements als ein zweiter Beschichtungsstoff bevorzugt verwendet. Der erste und der zweite Be-schichtungswerkstoff werden vorzugsweise durch Kathodenstrahlen zerstäubt, die durch unterschiedliche Generatoren erzeugt werden. Ein Farbeffekt tritt aber auch schon dann auf, wenn nur ein Beschichtungsstoff wie beispielsweise Magnesium verwendet wird.

Da Seltenerdelemente auf Grund ihrer aufwendigen Trennung als Mischmetall erhältlich sind, bezieht sich der Begriff "Mischung" im vorliegenden Zusammenhang auf Mischungen oder Legierungen der genannten Elemente, die durch einen Kathodenstrahl zerstäubt werden, der durch nur einen Generator erzeugt wird. So wird beispielsweise eine Kombination von Magnesium als ein erster Beschichtungsstoff und Lanthan, Yttrium, Praseodym, Gadolinium, Dysprosium oder einem Seltenderdmischmetall als ein zweiter Beschichtungsstoff besonders bevorzugt verwendet.

Das Atomverhältnis zwischen erstem Beschichtungsstoff und zweitem Beschichtungsstoff beträgt vorzugsweise 95:5 bis 1:1, besonders bevorzugt 20:1 bis 2:1 und insbesondere 5:1 bis 2:1.

Als Edelgas wird vorzugsweise Argon und/oder Xenon, insbesondere Argon verwendet. Als ein zweites Gas wird N₂, Stickstoff oder Kombinationen von Stickstoff und Sauerstoff wie z.B. Luft sind dabei besonders bevorzugt. Der Sputterdruck beträgt vorzugsweise 0,1 bis 10 Pa (absolut), bevorzugt 0,2 bis 5 Pa (absolut). Dabei werden besonders bevorzugt Gasgemische von Argon und Stickstoff und/oder Sauerstoff oder Gasgemische von Argon und SF₆ verwendet.

Das Molverhältnis von Argon zu Stickstoff und/oder Argon zu Sauerstoff beträgt in einem Gasgemisch von Argon und Stickstoff und/oder Sauerstoff bevorzugt 50:1 bis 1:2, besonders bevorzugt 3:1 bis 1:2.

Das Substrat ist vorzugsweise aus einem Metall gefertigt, besonders bevorzugt aus ein Element ausgewählt aus der Gruppe bestehend aus Mg, Al, Ga, In, Si, Ge, Sn, Pb, Ti, Zr, Hf, V, Nb, Ta, Cr, Mo, W, Mn, Fe, Co, Ni, Ru, Rh, Pd, Os, Ir, Pt oder Legierungen davon. Ganz besonders bevorzugt sind Substrate aus Mg, Al, Si oder Stahl.

Heutzutage werden insbesondere Telefongehäuse wie Mobiltelefongehäuse, Uhrengehäuse oder Gehäuse von Rechnern wie Laptops auf Grund des geringen Gewichts aus Magnesium oder einer Magnesiumlegierung hergestellt. Eine Lackierung der Magnesiumoberfläche ist aber sehr aufwändig und kann bei Gebrauch leicht beschädigt werden.

Mit dem erfindungsgemäßen Verfahren lassen sich insbesondere auf metallischen Oberflächen wie Magnesiumoberflächen fest haftende farbige Beschichtungen herstellen. Die Überzugsschicht wird vorzugsweise in einer Dicke von mindestens 30 nm, bevorzugt 100 nm bis 100 µm und am meisten bevorzugt 1 µm bis 10 µm aufgetragen. Die Farbe der Beschichtung kann durch Veränderung der Menge und Art des zweiten Gases variiert werden. Es wird daher vermutet, dass dieses in die Gitterstruktur der auf der Oberfläche des Substrats entstehenden metallischen Schicht, die gegebenenfalls eine Legierungsschicht ist, eingebaut wird.

Die Erfindung wird nunmehr durch das folgende Beispiel erläutert, dass die Erfindung nicht einschränken soll:

### Beispiel:

Eine typische Schicht wurde mit folgenden Prozessparametern hergestellt: Der Basisdruck vor der Beschichtung lag bei etwa 10⁻⁸ mbar. Das Substrat wurde rotiert und ständig gekühlt.

Gesputtert wurde mit einem Gasfluss von 28 sccm, der sich aus Argon- und Stickstoffgas in einem Verhältnis von 3:2 zusammensetzte. Das hatte einen Sputterdruck von 0.2 Pa zur Folge. Die Beschichtung erfolgte über 20 min. Die ersten 10 s wurde nur Yttrium mit Argon und danach beide Elemente Mg und Y mit dem Gasgemisch deponiert.

Bei diesen Parametern ergab sich eine Schichtdicke von etwa 0,7 µm, dies konnte aus vorher ermittelten Raten abgeschätzt werden. Der Film zeigte nach dem Ausschleusen aus dem Vakuumsystem eine grüne Farbe.

## Patentansprüche

1. Verfahren zur Erzeugung einer farbigen Überzugsschicht auf einem Substrat mittels Kathodenstrahlzerstäuben (Sputtern) einer Kombination von mindestens zwei Beschichtungsstoffen (Targets), wobei ein erster Beschichtungsstoff Magnesium und ein zweiter Beschichtungsstoff ein Element, ausgewählt aus der Gruppe bestehend aus La, Y, Ce, Pr, Nd, Pm, Sm, Eu, Gd, Tb, Dy, Ho, Er, Tm, Yb, Lu oder Mischungen derselben ist, und dass das Kathodenstrahlzerstäuben unter Einsatz eines Gasgemisches erfolgt, das ein Edelgas als erstes Gas sowie N₂ als zweites Gas enthält.

2. Verfahren nach Anspruch 1, **dadurch gekennzeichnet, dass** als Edelgas Argon verwendet wird.

3. Verfahren nach Anspruch 1 oder 2, **dadurch gekennzeichnet, dass** das Kathodenstrahlzerstäuben unter Einsatz eines Gasgemisches aus Argon und Stickstoff erfolgt und das Molverhältnis von Argon zu Stickstoff 50:1 bis 1:2 beträgt.

4. Verfahren nach einem der vorgehenden Ansprüche, **dadurch gekennzeichnet, dass** das Atomverhältnis zwischen erstem Beschichtungsstoff und zweitem Beschichtungsstoff 95:5 bis 1:1 beträgt.

5. Verfahren nach Anspruch 4, **dadurch gekennzeichnet, dass** das Atomverhältnis zwischen erstem Beschichtungsstoff und zweitem Beschichtungsstoff 3:1 bis 1:1 beträgt.

6. Verfahren nach einem der Ansprüche 1 bis 5, **dadurch gekennzeichnet, dass** der zweite Beschichtungsstoff ein Seltenerd-Mischmetall ist.

7. Verfahren nach einem der Ansprüche 1 bis 5, **dadurch gekennzeichnet, dass** der zweite Beschichtungsstoff ein Element, ausgewählt aus der Gruppe bestehend aus Lanthan, Yttrium, Praseodym, Gadolinium und/oder Dysprosium ist.

8. Verfahren nach einem der vorgehenden Ansprüche, **dadurch gekennzeichnet, dass** das Substrat aus einem Metall gefertigt ist.

9. Verfahren nach Anspruch 8, **dadurch gekennzeichnet, dass** das Metall des Substrats ein Element ausgewählt aus der Gruppe bestehend aus Mg, Al, Ga, In, Si, Ge, Sn, Pb, Ti, Zr, Hf, V, Nb, Ta, Cr, Mo, W, Mn, Fe, Co, Ni, Ru, Rh, Pd, Os, Ir, Pt oder Legierungen davon sind.

10. Verfahren nach Anspruch 9, **dadurch gekennzeichnet, dass** das Metall des Substrats ein Element ausgewählt aus der Gruppe bestehend aus Mg, Al, Si oder Stahl ist.

11. Verfahren nach einem der vorgehenden Ansprüche, **dadurch gekennzeichnet, dass** die Überzugsschicht in einer Dicke von 30 nm bis 100 µm aufgetragen wird.

## Claims

1. Method for producing a coloured coating on a substrate using cathodic sputtering of a combination of at least two coating substances (targets), wherein a first coating substance is magnesium and a second coating substance is an element selected from the group consisting of La, Y, Ce, Pr, Nd, Pm, Sm, Eu, Gd, Tb, Dy, Ho, Er, Tm, Yb, Lu or mixtures thereof, and wherein the cathodic sputtering takes place using a gas mixture which includes a noble gas as a first gas and N₂ as a second gas.

2. Method according to claim 1, **characterized in that** argon is used as noble gas.

3. Method according to claim 1 or 2, **characterized in that** the cathodic sputtering takes place using a gas mixture of argon and nitrogen, and wherein the molar ratio of argon to nitrogen is from 50:1 to 1:2.

4. Method according to any of the previous claims, **characterized in that** the atomic ratio of first coating substance to second coating substance is from 95:5 to 1:1.

5. Method according to claim 4, **characterized in that** the atomic ratio of first coating substance to second coating substance is from 3:1 to 1:1.

6. Method according to any of claims 1 to 5, **characterized in that** the second coating substance is a mixed metal of the rare earth elements.

7. Method according to any of claims 1 to 5 **characterized in that** the second coating substance is an element selected from the group consisting of lanthanum, yttrium, praseodym, gadolinium and/or dysprosium.

8. Method according to any of the previous claims, **characterized in that** the substrate is made of a metal.

9. Method according to claim 8, **characterized in that** the metal of the substrate is an element selected from the group consisting of Mg, Al, Ga, In, Si, Ge, Sn, Pb, Ti, Zr, Hf, V, Nb, Ta, Cr, Mo, W, Mn, Fe, Co, Ni, Ru, Rh, Pd, Os, Ir, Pt or alloys thereof.

10. Method according to claim 9, **characterized in that** the metal of the substrate is an element selected from the group consisting of Mg, Al, Si or steel.

11. Method according to any of the previous claims, **characterized in that** the overcoating layer is applied in a thickness of from 30 nm to 100 µm.

## Revendications

1. Procédé servant à produire une couche de revêtement colorée sur un substrat au moyen d'une pulvérisation de faisceau cathodique (pulvérisateurs cathodiques) d'une combinaison d'au moins deux matières d'enduction (cibles), une première matière d'enduction étant du magnésium et une deuxième matière d'enduction étant un élément choisi parmi le groupe constitué de La, Y, Ce, Pr, Nd, Pm, Sm, Eu, Gd, Tb, Dy, Ho, Er, Tm, Yb, Lu ou des mélanges de ces derniers, et la pulvérisation de faisceau cathodique ayant lieu en utilisant un mélange gazeux contenant un gaz noble en tant que premier gaz ainsi que du N₂ en tant que deuxième gaz.

2. Procédé selon la revendication 1, **caractérisé en ce qu'**on utilise comme gaz noble de l'argon.

3. Procédé selon la revendication 1 ou 2, **caractérisé en ce que** la pulvérisation de faisceau cathodique est effectuée en utilisant un mélange gazeux d'argon et d'azote, et **en ce que** le rapport molaire de l'argon par rapport à l'azote est compris entre 50:1 et 1:2.

4. Procédé selon l'une quelconque des revendications précédentes, **caractérisé en ce que** le rapport atomique entre la première matière d'enduction et la deuxième matière d'enduction est compris entre 95:5 et 1:1.

5. Procédé selon la revendication 4, **caractérisé en ce que** le rapport atomique entre la première matière d'enduction et la deuxième matière d'enduction est compris entre 3:1 et 1:1.

6. Procédé selon l'une quelconque des revendications 1 à 5, **caractérisé en ce que** la deuxième matière d'enduction est un métal mixte à base de terres rares.

7. Procédé selon l'une quelconque des revendications 1 à 5, **caractérisé en ce que** la deuxième matière d'enduction est un élément choisi parmi le groupe constitué de lanthane, d'yttrium, de praséodyme, de gadolinium et/ou de dysprosium.

8. Procédé selon l'une quelconque des revendications précédentes, **caractérisé en ce que** le substrat est fabriqué à partir d'un métal.

9. Procédé selon la revendication 8, **caractérisé en ce que** le métal du substrat est un élément choisi parmi le groupe constitué de Mg, Al, Ga, In, Si, Ge, Sn, Pb, Ti, Zr, Hf, V, Nb, Ta, Cr, Mo, W, Mn, Fe, Co, Ni, Ru, Rh, Pd, Os, Ir, Pt ou d'alliages de ces derniers.

10. Procédé selon la revendication 9, **caractérisé en ce que** le métal du substrat est un élément choisi parmi le groupe constitué de Mg, Al, Si ou d'acier.

11. Procédé selon l'une quelconque des revendications précédentes, **caractérisé en ce que** la couche de revêtement est appliquée en une épaisseur allant de 30 nm à 100 µm.
